# EUROPEAN PATENT APPLICATION

(11) **EP 3 576 164 A1**
(43) Date of publication of application: **04.12.2019**
(21) Application number: 18196759.7
(22) Date of filing: 26.09.2018
(51) Int. Cl.: H01L 31/18, H01L 21/683

(54) **LOADING TRAY FOR DOUBLE-SIDED FILM COATING, SILICON CHIP LOADING DEVICE AND SILICON CHIP CONVEYING SYSTEM**

(30) Priority: 28.05.2018 CN 201820803855 U
(71) Applicant: Beijing Juntai Innovation Technology Co., Ltd, 100176 Beijing (CN)
(72) Inventor: ZHANG, Wen, Beijing, 100176 (CN)
(74) Representative: D'Halleweyn, Nele Veerle Trees Gertrudis

(57) **Abstract**

A loading tray for film coating, a silicon chip loading device and a silicon chip conveying system are provided. The loading tray includes a cover plate (1) provided with a through first depositing window (3), and a bottom plate (2) provided with a through second depositing window (4). The opening size of the second depositing window is larger than that of the first depositing window. A support portion (5) for carrying a silicon chip (100) is arranged on an inner wall of the second depositing window. The cover plate is fitted and connected to the bottom plate. The silicon chip loading device includes a loading plate and the loading tray. The loading tray is placed on the loading plate, and the bottom plate is connected to the loading plate. The silicon chip conveying system includes a conveying device and the loading tray or the silicon chip loading device.

## Description

This application claims the priority of the Chinese patent application No. 201820803855.1, filed on May 28, 2018, the entire content of which is hereby incorporated by reference.

### Technical Field

The present disclosure relates to, but is not limited to, the field of manufacturing silicon-based photovoltaic assembly, and in particular relates to a loading tray for film coating, a silicon chip loading device, and a silicon chip conveying system.

### Background

In the process of producing double-sided solar cells, due to the need to perform film coating process on both sides of the silicon chip, it is usually necessary for the operator to place the cell silicon chip in the tray of the silicon chip conveying system. Since the bottom of the tray is of a closed structure, after the deposition of one side is completed, the silicon chip needs to be manually turned over, placed in the tray, and conveyed to the film coating apparatus again so as to perform the film coating process on the other side, thus completing the double-sided film coating.

The manual operation of turning over the silicon chip in the tray is tedious and time-consuming.

### Summary

At least one embodiment of the present disclosure provides a loading tray for film coating which includes: a cover plate provided with a through first depositing window; and a bottom plate provided with a through second depositing window. The opening size of the second depositing window is larger than that of the first depositing window. A support portion for carrying a silicon chip is arranged on an inner wall of the second depositing window. The cover plate is fitted and connected to the bottom plate.

At least one embodiment of the present disclosure provides a silicon chip loading device which includes a loading plate and the loading tray described above. The loading tray is placed on the loading plate and the bottom plate is connected to the loading plate.

At least one embodiment of the present disclosure provides a silicon chip conveying system which includes a conveying device and the loading tray described above. The conveying device is configured for conveying the loading tray.

At least one embodiment of the present disclosure provides a silicon chip conveying system which includes a conveying device and the silicon chip loading device described above. The conveying device is configured for conveying the silicon chip loading device.

### Brief Description of Drawings

FIG. 1 is a schematic isometric view of a loading tray according to an embodiment of the present disclosure;
FIG. 2 is a schematic longitudinal sectional view of a loading tray according to an embodiment of the present disclosure;
FIG. 3 is a schematic isometric view of a bottom plate according to an embodiment of the present disclosure;
FIG. 4 is a schematic isometric view of a bottom plate according to another embodiment of the present disclosure;
FIG. 5 is a schematic longitudinal sectional view of a loading tray according to another embodiment of the present disclosure.

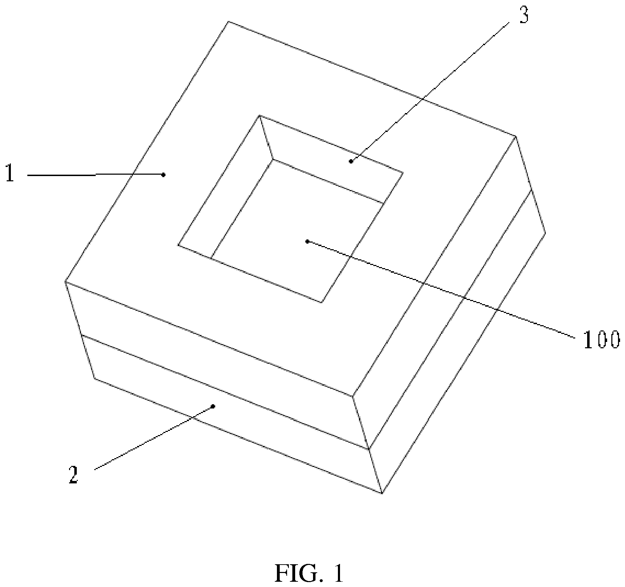

The correspondence between the reference signs and the components in FIGs. 1 to 5 is as follows:
1 -- cover plate, 2 -- bottom plate, 3 -- first depositing window, 4 -- second depositing window, 5 -- support portion, 6 -- support piece, 7 -- positioning hole, 100 -- silicon chip.

### Detailed Description

Hereinafter, embodiments of the present disclosure will be described in detail in combination with the accompanying drawings. It should be appreciated that, if without conflict, the embodiments and features in the embodiments of the present disclosure may be combined with each other arbitrarily.

In order to overcome the defects of the conventional loading tray, an embodiment of the present disclosure provides a loading tray in which a silicon chip is clamped. There is no need to turn over the silicon chip in the loading tray during the double-sided film coating process, and instead the double-sided depositing process can be carried out through the first and second depositing windows by simply directly rotating the loading tray, thus saving labor cost and simplifying the operation process. In addition, the chance for operators to directly contact the silicon chips can be reduced, thus the damage rate of the silicon chips can be reduced, and the production efficiency can be effectively improved.

The loading tray, the silicon chip loading device and the silicon chip conveying system of the present disclosure will be described below in combination with the embodiments.

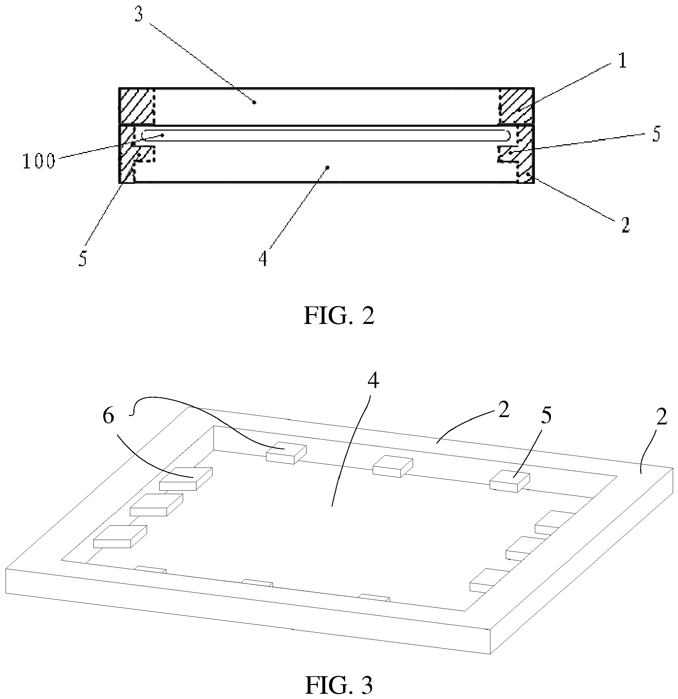

As shown in FIGs. 1 and 2, an embodiment of the present disclosure provides a loading tray, which mainly includes a cover plate 1 and a bottom plate 2. The cover plate 1 and the bottom plate 2 can be made of a material, such as graphite, carbon fiber, aluminum alloy or stainless steel, etc. Specifically, the cover plate 1 is provided with a through first depositing window 3 extending through the cover plate 1 from a top surface to a bottom surface of the cover plate 1, and the longitudinal section of the first depositing window 3 is rectangular in shape, which can ensure machining convenience and maximize the film coating area. In addition, the bottom plate 2 is provided with a through second depositing window 4 extending through the bottom plate 2 from a top surface to a bottom surface of the bottom plate 2, and an inner wall of the second depositing window 4 is fixedly provided with a support portion 5 for carrying a silicon chip 100. In an assembled loading tray, the silicon chip 100 is placed on the support portion 5 of the bottom plate 2, and the cover plate 1 and the bottom plate 2 are fitted to each other by a connector. It can be understood by those skilled in the art that the cover plate 1 and the bottom plate 2 are fitted to each other in such a manner that they are formed into one piece by covering each other. The connector can be at least one of a magnetic attracting means, a screwing means, a locking means and the like. In order to ensure that the silicon chip 100 will not fall off when the loading tray is turned over, the opening size of the second depositing window 4 should be larger than the opening size of the first depositing window 3. That is, in the case that the loading tray is turned over and the bottom plate 2 is at an upper position and the cover plate 1 is at a lower position, the cover plate 1 is capable of supporting the silicon chip 100.

As can be understood by those skilled in the art, the function of the two depositing windows is, as implied by the names, to deposit coatings on the upper and lower surfaces of the supported silicon chip 100. That is, after the cover plate 1 and the bottom plate 2 are fitted to each other, the loading tray is formed into a through structure from top to bottom by the above two depositing windows (when the silicon chip 100 is not placed between the cover plate 1 and the bottom plate 2). The opening shape (not the longitudinal section) of the depositing window may be rectangular as shown in FIG. 1, or may be determined by the shapes of different silicon chips to be processed. In addition, the ratio of the opening sizes of the two depositing windows can be set to a certain value, so that the exposed areas of the upper and lower end faces of the silicon chip 100 are the same, and then the coated areas of the two sides of the silicon chip 100 can be the same.

In an exemplary embodiment of the present disclosure, as shown in FIGs. 2 and 3, the support portion 5 is located in the middle of the inner wall of the second depositing window 4 so that the bottom plate 2 can be used bi-directionally up and down, that is, in case one side of upper and lower sides of the bottom plate 2 is damaged, the other side thereof can be cooperated with the cover plate 1.

In addition, in an exemplary embodiment of the present disclosure, as shown in FIG. 3, the support portion 5 includes a plurality of separate support pieces 6 which are projections protruding from the inner wall of the second depositing window 4. The plurality of support pieces 6 may be uniformly distributed on one or more inner walls of the second depositing window 4. The uniform distribution herein specifically means that the distances between adjacent support pieces 6 are equal.

Another embodiment of the present disclosure provides a loading tray. In this embodiment, the loading tray is provided with a positioning means.

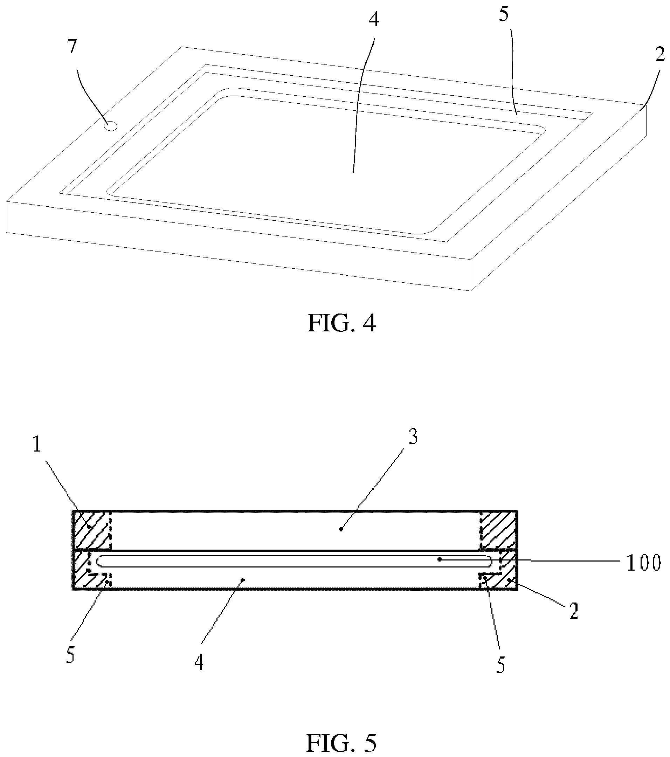

As shown in FIG. 4, in order to ensure the cover plate 1 and the bottom plate 2 are accurately and conveniently snap-fitted with each other, the cover plate 1 and the bottom plate 2 of the loading tray are locked in position accurately by the positioning means so as to avoid deviation. In particular, the bottom plate 2 is provided with a positioning hole 7, and the cover plate 1 is provided with a positioning pin matched with the positioning hole 7. Alternatively, the positioning pin may be provided on the bottom plate 2, and the positioning hole 7 is provided on the cover plate 1.

In an exemplary embodiment of the present disclosure, the support portion 5 is of an integral structure, that is, the support portions 5 on each inner wall are connected to each other and the support portions 5 on adjacent inner walls are connected to each other. Such arrangement, compared with the arrangement of separate sections, presents a continuous structure. In particular, the support portion 5 is a block-like protruding structure arranged along a direction perpendicular to the inner wall of the second depositing window 4 as shown in the figure. The support portion 5 can be welded to or integrally formed with the bottom plate 2, for example, by using a mold.

Another embodiment of the present disclosure provides a loading tray. In this embodiment, the support portion is located at the bottom of the inner wall of the second depositing window.

As shown in FIG. 5, the support portion 5 is arranged at the bottom of the inner wall of the second depositing window 4, and the silicon chip 100 is sandwiched between the support portion 5 and the cover plate 1. The bottom plate 2 is small in thickness, needs relatively less space, and is easier to process.

An embodiment of the present disclosure provides a silicon chip loading device, which includes a loading plate and a loading tray described in at least one embodiment above. The loading tray is placed on the loading plate, and the bottom plate is connected with the loading plate. For example, the silicon chip loading device may include only the loading tray described in any one of the above embodiments, or include the loading trays described in any two embodiments, or include the loading trays described in three embodiments, and so on. Specifically, the loading trays are arranged on the loading plate in a 4 × 7 matrix, and can be installed and fixed on the loading plate by way of positioning pins or mounting holes, etc.

An embodiment of the present disclosure provides a silicon chip conveying system, which includes a conveying device and a loading tray described in at least one embodiment above. The conveying device can be any of various conveying devices, such as a robot arm, a roller or a conveyor belt, etc. The loading tray is placed on the conveying device, and the bottom plate is connected with the conveying device so as to convey silicon chips. For example, the robot arm can convey the loading tray by directly clamping it, and in the embodiment where a conveying roller is used, the loading tray can be directly placed on the roller.

An embodiment of the present disclosure also provides a silicon chip conveying system, which includes a conveying device and the silicon chip loading device described above. The silicon chip loading device is placed on the conveying device. The conveying device can be any of various conveying devices, such as a robot arm, a roller or a conveyor belt, etc. The robot arm can carry out the conveying by clamping the loading plate, and in the embodiment where a conveying roller is used, the loading plate can be placed on the roller.

In this disclosure, the term "a plurality of' refers to two or more than two.

The above described embodiments merely represent several embodiments of the present disclosure, the description of which is specific and detailed. These embodiments are provided for easy understanding the present disclosure, but not intended to limit this disclosure. A person skilled in the art to which this disclosure pertains may make various modifications and changes to the form and details of the embodiments without departing from the spirit and scope of the disclosure. The patent protection scope of this disclosure should be defined by the appended claims.

## Claims

1. A loading tray for film coating, comprising:
a cover plate (1) provided with a through first depositing window (3); and
a bottom plate (2) provided with a through second depositing window (4), wherein an opening size of the second depositing window (4) is larger than that of the first depositing window (3), and a support portion (5) for carrying a silicon chip (100) is arranged on an inner wall of the second depositing window (4); and
the cover plate (1) is fitted and connected to the bottom plate (2).

2. The loading tray according to claim 1, wherein the longitudinal section of the first depositing window (3) is rectangular in shape.

3. The loading tray according to claim 2, wherein the cover plate (1) and the bottom plate (2) are fitted and connected to each other through a connector.

4. The loading tray according to claim 1, wherein the support portion (5) is located in the middle or at the bottom of the inner wall of the second depositing window (4).

5. The loading tray according to claim 3, wherein the cover plate (1) is provided with a positioning pin, and the bottom plate (2) is provided with a positioning hole (7) matched with the positioning pin.

6. The loading tray according to claim 3, wherein the connector comprises at least one of a magnetic attracting means, a screwing means and a locking means.

7. The loading tray according to any one of claims 1-6, wherein a material of the cover plate (1) and the bottom plate (2) is selected from the group consisting of graphite, carbon fiber, aluminum alloy and stainless steel.

8. The loading tray according to any one of claims 2-6, wherein the support portions (5) on each inner wall of the second depositing window (4) are connected to each other, and the support portions (5) on adjacent inner walls of the second depositing window (4) are connected to each other.

9. The loading tray according to claim 8, wherein the support portion (5) is a protruding block arranged along a direction perpendicular to the inner wall of the second depositing window (4).

10. The loading tray according to any one of claims 1-6, wherein the support portion (5) comprises a plurality of separate support pieces (6).

11. The loading tray according to claim 10, wherein the distances between the adjacent support pieces (6) are equal.

12. A silicon chip loading device, comprising a loading plate and the loading tray according to any one of claims 1-11, wherein the loading tray is placed on the loading plate and the bottom plate (2) is connected to the loading plate.

13. The silicon chip loading device according to claim 12, wherein a plurality of the loading trays placed on the loading plate are arranged in a matrix.

14. A silicon chip conveying system, comprising a conveying device and the loading tray according to any one of claims 1-11, wherein the conveying device is used for conveying the loading tray.

15. A silicon chip conveying system, comprising a conveying device and the silicon chip loading device according to claim 12 or 13, wherein the conveying device is used for conveying the silicon chip loading device.
